# EUROPEAN PATENT SPECIFICATION

(11) **EP 4 403 000 B1**
(45) Date of publication and mention of the grant of the patent: **02.12.2026**
(21) Application number: 22777348.8
(22) Date of filing: 15.09.2022
(51) Int. Cl.: H05K 7/20, F04D 29/58, F04D 29/60, F24F 1/0033, F24F 13/00

(54) **IMPROVED FAN WALL MODULE AND FAN WALL UNIT ARRANGEMENT COMPRISING SUCH FAN WALL MODULE**
VERBESSERTES LÜFTERWANDMODUL UND LÜFTERWANDEINHEITSANORDNUNG MIT SOLCH EINEM LÜFTERWANDMODUL
MODULE DE PAROI DE VENTILATEUR AMÉLIORÉ ET AGENCEMENT D'UNITÉ DE PAROI DE VENTILATEUR COMPRENANT UN TEL MODULE DE PAROI DE VENTILATEUR

(30) Priority: 15.09.2021 IT 202100023759
(43) Date of publication of application: 24.07.2024
(73) Proprietor: Mitsubishi Electric Hydronics & IT Cooling Systems S.p.A., 36061 Bassano del Grappa (Vicenza) (IT)
(72) Inventor: CALTABELLOTTA, Giuseppe, 36061 BASSANO DEL GRAPPA (VI) (IT); LIZZOLI, Matteo, 36061 BASSANO DEL GRAPPA (VI) (IT)
(74) Representative: Studio Torta S.p.A.
(86) International application number: PCT/IB2022/058688
(87) International publication number: WO 2023/042102

(56) References cited:
- CN-A- 110 529 926
- CN-U- 210 343 803
- CN-U- 210 601 944
- CN-U- 212 029 855
- CN-U- 212 928 239
- CN-U- 213 687 040
- US-A1- 2009 129 913
- US-A1- 2020 229 323
- US-A1- 2021 161 032
- US-B2- 10 375 862

## Description

### Technical Field

The present invention concerns a fan wall module, in particular a fan wall module of a conditioning fan wall unit arrangement.

The present invention finds its preferred, although not exclusive, application in IT device conditioning, such as data hall conditioning. Reference will be made to this application by way of example below.

### Background of the Invention

IT devices needs to be maintained within a pre-set temperature range to allow an optimized operation. Indeed, for sake of example, it is known that the elaboration of data by an IT device produces heat that should be dissipated, taking into account the environmental temperature, in order to allow the correct operation of the IT device.

An example of such IT devices are data halls that are provided with so-called fan wall units that are voted to their conditioning.

Fan wall units are constructed in a modular way so that a single fan wall module is overlapped side-by-side, i.e. on the left and/or the right and upper and/or lower by another fan wall module in order to cover the entire data hall surface with fan modules.

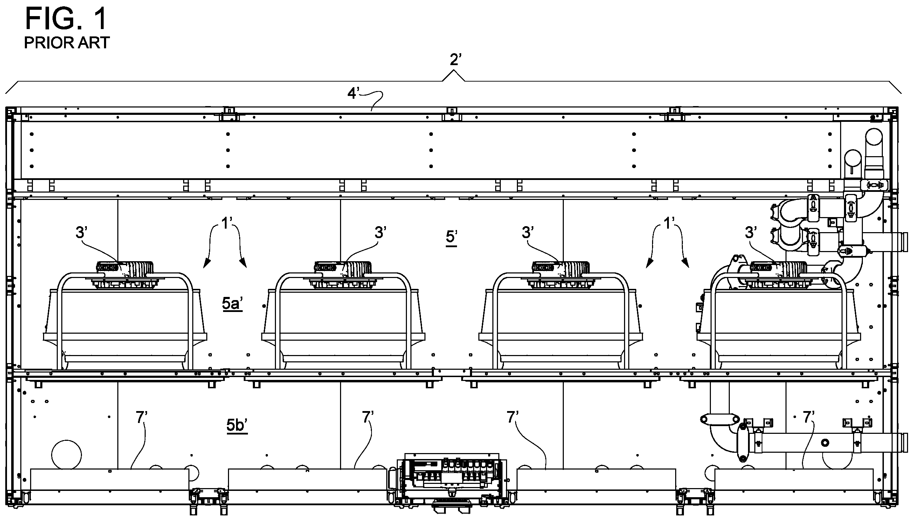

Figure 1 discloses a prior art known arrangement of a row of fan modules of a fan wall unit arrangement.

As can be appreciated, the fan wall modules 1' are arranged linearly in front of IT device 2' such as a data hall. The modules 1' comprises essentially a fan 3' that is rigidly carried by a frame 4' defining a space 5' that houses the fan 3'. The frame 4' comprises a plate 6' on which the fan 3' is mounted that divides the space 5' into a negative pressure portion 5a' and a positive pressure portion 5b'.

The positive pressure portion 5b' houses heat exchanger assembly provided conduits for allowing passage of conditioning fluid while the negative pressure portion 5a' houses filters 7' for the fan 3'.

Clearly, since the positive pressure portion 5b' is faced to the IT device 2', that is fixed to ground, a user may provide maintenance of the elements in positive pressure portion 5b' only by disassembling the fan 3' from the plate 6' and, if necessary also plate 6' from framework 4'.

Accordingly, it is clear that the maintenance or the inspection of the elements contained in positive pressure portion 5b' is a long, costly operation that cannot be executed often, thereby increasing the risk of malfunctioning of the system.

Moreover, as said, each module 1' is connected side-by-side to the other. Accordingly, during the relative mounting of each module 1' it is necessary to pay attention to correctly match the relative positions between the modules in order to allow the connection of the conduits that allow the circulation of conditioning fluid.

If such positioning is not correct, e.g. due to standard tolerances, in case of the presence of multiple rows of modules 1', it may be necessary to provide joint conduits with a designed specific shape to compensate the different position of the conduits of each module.

Again, such need of providing peculiar joints increases costs and installation time of the fan wall arrangement.

Examples of known system in the art are disclosed in publications US2020/229323 A1, CN210343803 U, CN210601944U or US2009/129913 A1.

In view of the above drawbacks, the need is felt to provide a fan wall module for a fan wall unit arrangement that has an easy installation and that allows an easy maintenance of all its elements.

An aim of the present invention is to satisfy the above mentioned needs in a cost effective, compact and optimized manner.

### Summary of the Invention

The aforementioned aim is reached by a fan wall module and a fan wall unit arrangement as claimed in the appended set of claims.

### Brief Description of Drawings

For a better understanding of the present invention, a preferred embodiment is described in the following, by way of a non-limiting example, with reference to the attached drawings wherein:
- Figure 1 is a schematic top sectioned view of a fan wall unit arrangement as known in the art;
- Figure 2 is a perspective view of a portion of a first arrangement of fan wall modules according to the present invention;
- Figure 3 is a perspective view, with parts removed for sake of clarity, of a portion of the fan wall modules according to the present invention in an operational condition;
- Figure 4 is a front view of the portion of figure 3;

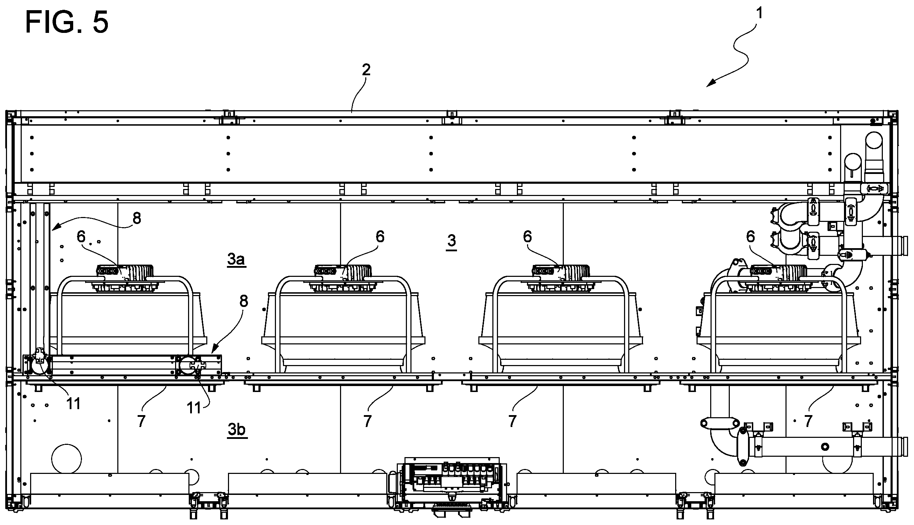

- Figure 5 is a top sectioned view of the portion of figure 3;
- Figure 6 is a perspective view of a second arrangement of fan wall modules not making part of the present invention but useful to its understanding; and

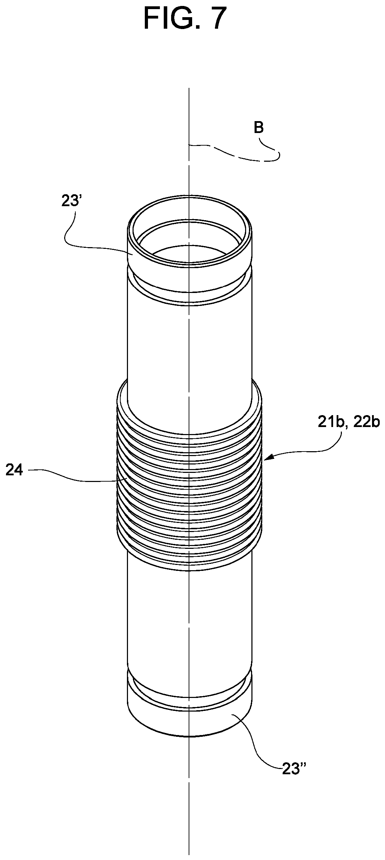

- Figure 7 is a perspective view of an element of the fan wall units arrangement of figure 6.

### Detailed Description of the Invention

Figure 1 discloses a fan wall unit arrangement 1 comprising a plurality of fan modules 4, as shown, arranged laterally one with respect to the other along a longitudinal axis A one with respect to the other.

The arrangement 1 comprises a frame 2 provided with a plurality of rods and walls to delimit a space 3 into which the plurality of fan modules 4 are arranged.

In greater detail, each fan module 4 is faced to an IT device (not shown) such as a data hall, on a first side and, on a second side opposite to the first side each module 4 is faced to a frame wall defined by frame 2.

In the disclosed example, the frame wall of each fan module 4 is provided with a door 5 configured to be hinged with to frame 2 in order to assume a first, closed, configuration wherein the space 3 is separated from the environment and a second, opened, configuration wherein the space 3 is communicating with the environment.

As exemplarily disclosed, preferably, the doors 5 of two adjacent fan modules 4 are placed in order to open on opposite sides thereby, when opened together, they allow a greater communicating area between the space 3 and the environment.

More preferably and as per se known, such door 5 or the walls of each fan module 4 on the second side and the first side of frame 2 are provided with openings configured to allow the passage of air; in particular in the disclosed embodiment such openings houses corrugated filters suitable for air filtration.

Other details about frame 2, the rods/walls comprised by the latter and their fixation are not further disclosed for sake of brevity being clear that the disclosed shape and mounting may be varied according to the dimension and needs of the IT device to be conditioned.

In detail, each fan module 4 comprises a portion of frame 2 that can be connected to another portion of frame 2 of another fan module 4. Such portion of frame 2 is configured to carry a fan assembly 6 that may be of any typology and that is configured to push out air through the IT device, i.e. from the first side of the module and suck such air on the opposite side, i.e. on the second side, through the door 5 / wall of frame 2.

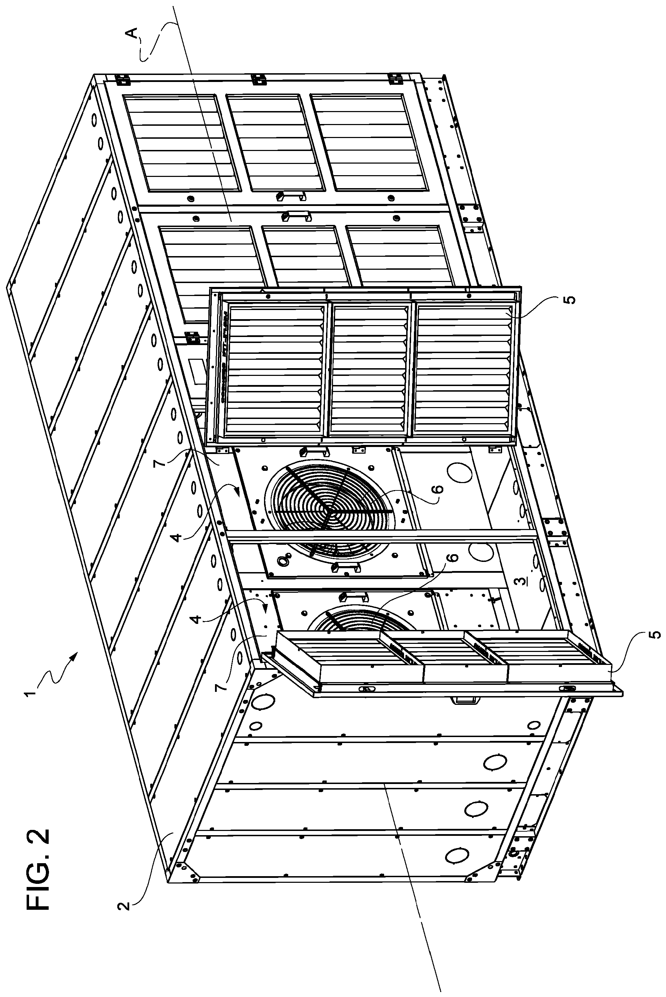

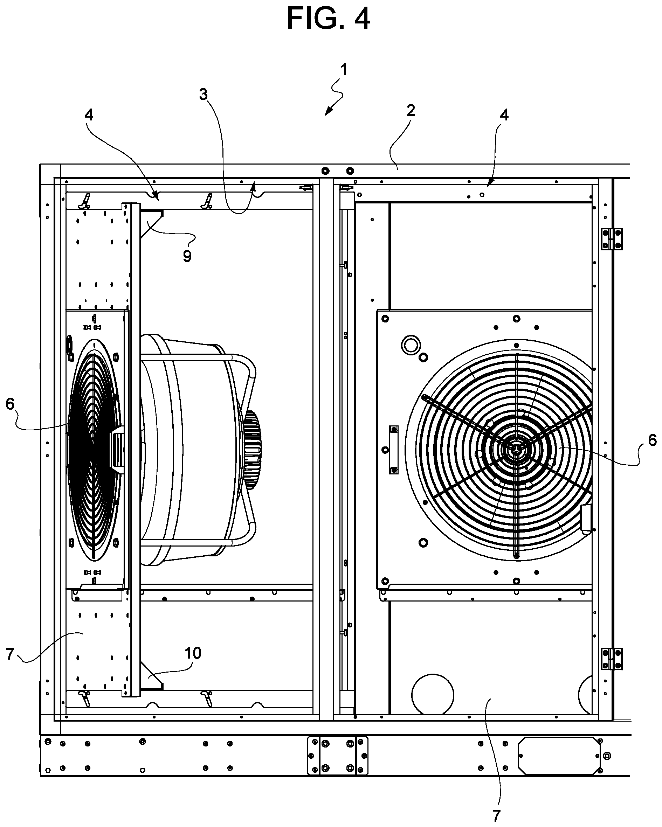

As can be appreciated by figures 2, 3 and 4, the fan assembly 6 is carried by a wall 7 that subdivide the space 3 into a positive pressure portion 3a and a negative pressure portion 3b, according to a standard operation of the fan assembly 6, i.e. pushing out air through the IT device. As exemplarily shown, the wall 7 defines an opening that is entirely occupied by fan assembly 6 configured to suck air from the negative pressure portion 3b and push out air into positive pressure portion 3a. In detail, the wall 7 is carried by the aforementioned portion of frame 2 and it is substantially flat and extends parallel to longitudinal axis A.

Even if not disclosed into detail, the positive pressure portion 3a houses heat exchangers and any other element need to the conditioning circuit to condition the IT device via fan assembly airflow, while the negative pressure portion 3b houses filters for allowing efficient operation of fan assembly 6.

Advantageously, the wall 7 is carried in a movable manner with respect to the portion of the frame 2 so that it can be displaced to allow to reach the positive pressure portion 3a from the negative pressure portion 3b.

In particular, at least one among the fan modules 4 comprised by the fan wall unit arrangement 1 may comprise a movable wall 7. Indeed, such one or some among the fan module 3 may provide access to the positive pressure portion 3a and the other may provide support to conduits, as described hereunder, for allowing the circulation of conditioning fluid.

Preferably, the wall 7 is movable in a sliding manner with respect to frame 2 in order to assume a plurality of positions between a first, closed, configuration, wherein the positive pressure portion 3a and the negative pressure portion 3b are separated by wall 7 that is secured to the frame 2 and a second, opened, configuration, wherein the positive pressure portion 3a and the negative pressure portion 3b are communicating with the maximum area passage between them.

In particular, in such second configuration, the wall 7 is substantially perpendicular to the longitudinal axis A direction.

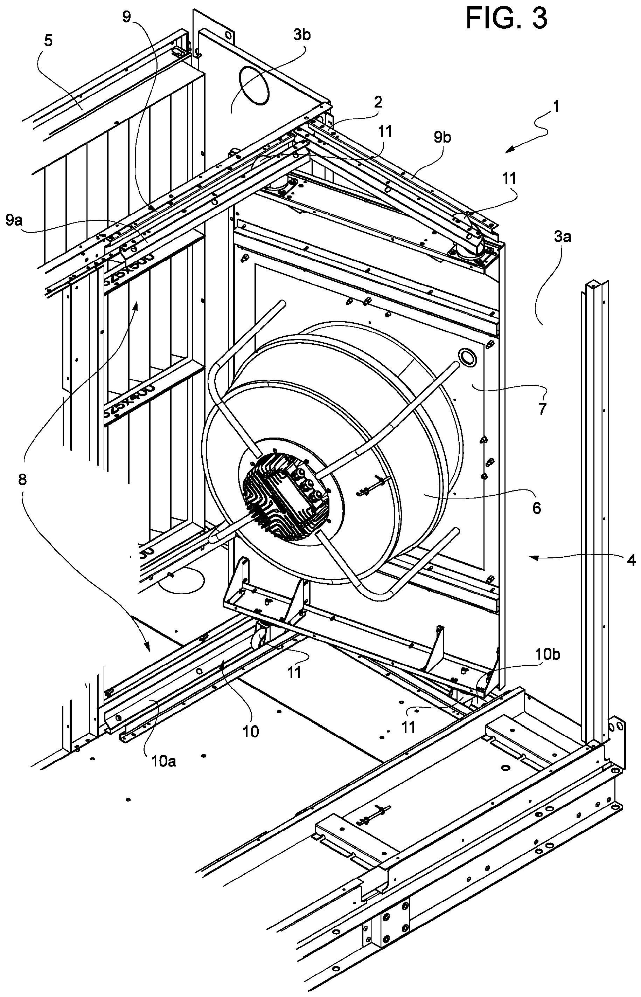

Making reference, in particular, to figure 3, the fan module 4 preferably comprise guide means 8 configured to support the wall 7 in a sliding manner with respect to the portion of frame 2 in order to assume the above defined positions.

Preferably, the fan module 4 comprises locking means, not shown, configured to lock the wall 7 in one between the first or the second configurations. Such locking means may be mechanical, such as screws, or magnetic locking means. More preferably, such locking means may be integrated into the guide means 8.

In the disclosed embodiment, the guide means 8 comprises an upper rail 9 and a lower rail 10 that are fixedly carried by the portion of frame 2 while the wall 7 comprises sliding elements 11, such as a pin or rollers as exemplarily shown, configured to respectively cooperate in sliding manner with the upper rail 9 and the lower rail 10 to allow the passage of wall 7 between the first and second configurations.

In greater detail, the upper and lower rails 9, 10 are realized, respectively, vertically over a top edge of the wall 7 and vertically under a bottom edge of the wall 7. Accordingly, the sliding elements 11 are carried by such top and bottom edges to cooperate with the respective upper and lower rails 9, 10.

In particular, according to the shown embodiment, the upper and lower rails 9, 10 comprise a first portion 9a, 10a parallel to axis A and a second portion 9b, 10b inclined with respect to the first portion 9a, 10a and preferably perpendicular to this latter, i.e. upper and lower rails 9, 10 are preferably "L-shaped".

In particular, the first and second portions 9a, 10a, 9b, 10b extend so that in the second configuration the wall 7 is substantially perpendicular to axis A.

The passage of wall 7 between the disclosed configurations may be achieved by the user pushing on the wall 7 (in case, after unlocking the wall 7), thereby allowing the movement of sliding elements 11 on the guide means 8. Clearly, an actuator may be provided to automatically move the wall 7 on the guide means 8, in function of a control signal.

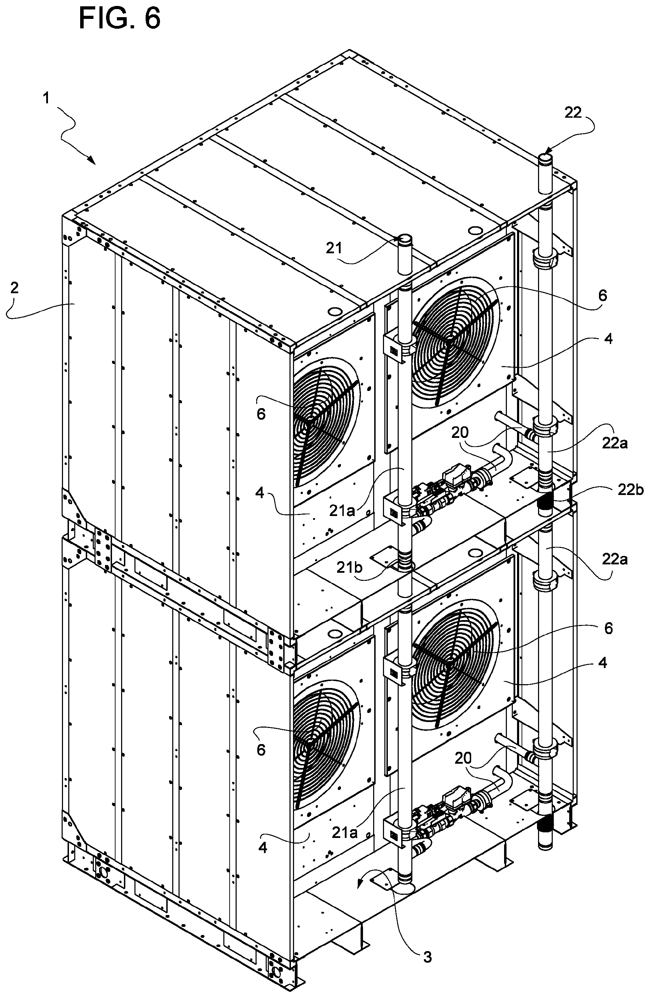

In figure 6 it is shown a further possible fan wall unit arrangement 1, not making part of the present invention but useful to its understanding, comprising a plurality of fan modules 4 disposed on two rows vertically placed one with respect to the other. In the following, reference will be made to the following consideration, the same would apply to vertical rows placed laterally adjacent one with respect to the other.

At least one per row among the fan wall modules 4 defines a passage for conduits 20 configured to allow the feeding or the return of the conditioning fluid to the heat exchanger assemblies housed in the negative pressure portion 3b of each fan module 4.

The feeding and return conduits 20 of each row are fluidly connected to a return main conduit 21 and a feeding main conduit 22 configured, respectively to divide between the different feeding conduits 20 the conditioning fluid and collect the conditioning fluid from the different return conduit 20 of each row.

Advantageously, the return and feeding main conduits 21, 22 comprises a main portion 21a, 22a fixedly carried by frame 2 of each fan module 4 and a connection portion 21b, 22b configured to fluidly connect together two main portions 21a, 22a of two different fan modules 4.

Advantageously, the connection portion 21b, 22b have a tubular form about an axis B and comprises a pair of extremity portions 23', 23'' and an intermediate portion 24 axially comprised along axis B between the extremity portions 23', 23". Preferably, the connection portions 21b, 22b are substantially cylindrical and are concentric with respect to intermediate portion 24.

The extremity portions 23', 23" are dimensioned to cooperate with respective main portions 21a, 22a of different fan modules 4 to allow the fluidic connection among them via intermediate portion 24.

Advantageously, the intermediate portion 24 is deformable in order to allow the displacement of the extremity portions 23', 23'' with respect to axis B according to its deformation, i.e. between a first, non-deformed, configuration wherein the intermediate portion 24 and the extremity portions 23', 23" are concentric and a second, deformed, configuration wherein the intermediate portion 24 and the extremity portions 23', 23" are no more concentric, i.e. displaced at least one with respect to the other.

Preferably, the intermediate portion 24 is realized as bellow-shaped, i.e. comprising a multiple V-shaped profile that allows a modification of length and/or inclination and/or transversal position between the extremity portions 23', 23".

In view of the above, it is underlined that the conduits 20, 21, 22 are all located within the frame 2, i.e. in the space 3 defined by the fan wall unit arrangement 1.

The operation of the above described fan wall unit arrangements according to the invention is the following.

During a mounting phase of the fan wall unit arrangement 1, the different rows of fan wall modules 4 can be mounted side-by-side one other or adjacent the other. The return and feeding main conduits 21, 22 are then connected via connection portion 21b, 22b. In particular, the extremity portions 23', 23" are connected to the main portions 21a, 22a of two different fan wall modules 4 and the intermediate portion 24 may be deformed in order to compensate any different relative positions between the main portions 21a, 22a of two different fan wall modules 4.

During a standard operative phase of fan wall unit arrangement 1, the wall 7 is in its first configuration and therefore the fan assembly suck air from the negative pressure portion 3b thereby conditioning the IT device placed in front of the first side of the fan wall unit arrangement 1.

During a maintenance/inspection phase of fan wall unit arrangement 1, the wall 7 is moved in its second configuration, thereby allowing a user to access to positive pressure portion 3a in an easy and comfortable way.

In view of the foregoing, the advantages of a fan module and a fan arrangement according to the invention are apparent.

Thanks to the proposed movable wall 7 that carries the fan assembly, the inspection/maintenance of the elements housed in the negative pressure portion is easier and quicker.

In particular, the used of sliding means that allows the total opening of the wall guarantees a wide access to the operator.

Moreover, the use of upper and lower rails allows to move in a light way the wall and the assembly, notwithstanding to its weight.

Furthermore, the presence of actuators for automatically moving the wall and/or of locking means for blocking the wall in its two limit configurations facilitate the displacement of this latter by the user.

The presence of coupling means having a deformable portion allows the user to easily and quick mounting two fan wall modules compensating possible mounting tolerances.

The use of a deformable portion realized as bellows is particularly compact, resistant and economic.

It is clear that modifications can be made to the described fan module and the fan arrangement which do not extend beyond the scope of protection defined by the claims.

For example, as said, the number of fan wall module 4 and rows may vary, such as the vertical or horizontal positioning of the disclosed conduits 20, 21, 22.

Similarly, more modules 4 may be provided with a movable wall 7 and fan assembly may be realized in different manners and comprise more than one fan.

Clearly, as said, the shape and typology of frame 2 may vary according to the number and dimension of modules 4.

Moreover, even in not described in combination for sake of drawings clarity, the two described embodiment of figures 1 and 6 can be combined together.

## Claims

1. Fan wall module (4) for a fan wall unit arrangement (1), said fan wall module (4) comprising a frame (2) suitable for being connected to other frame (2) of other fan wall modules (4), said frame (2) delimiting a space (3) suitable for housing a wall (7) carried by the frame (2), said fan wall module (4) comprising a fan assembly (6) supported by said wall (7), said wall (7) dividing said space (3) in a first portion (3a) and a second portion (3b), **characterized in that** said wall (7) is carried by said frame (2) in a movable manner so that said first portion (3a) can be reached through said second portion (3b).

2. Fan wall module according to claim 1, wherein said first portion (3a) is a positive pressure portion and said second portion (3b) is a negative pressure portion according to a standard operation of said fan assembly.

3. Fan wall module according to claim 1 or 2, wherein said wall (7) is carried in a movable way in order to assume a plurality of positions between a first, closed, configuration, wherein said first portion (3a) and said portion (3b) are separated by said wall (7) that is secured to said frame (2) and a second, opened, configuration, wherein the said first portion (3a) and said portion (3b) with a maximum area passage between them.

4. Fan wall module according to claim 3, wherein said wall (7) is positioned parallel to a longitudinal axis (A) of said fan wall module (4) when it is in said first configuration and wherein said wall (7) is positioned perpendicular to said longitudinal axis (A) when it is in said second configuration.

5. Fan wall module according to any of claims 3 or 4, comprising guide means (8) configured to support the wall (7) in a sliding manner with respect to said frame (2) in order to achieve said configurations.

6. Fan wall module according to claim 5, wherein said guide means (8) comprises an upper and a lower rails (9, 10), said wall (7) comprising sliding means (11) configured to cooperate with said upper and lower rails (9, 10) in sliding manner.

7. Fan wall module according to claim 6 in combination with claim 4, wherein said upper and lower rails (9, 10) comprises a first portion (9a, 10a) parallel to said longitudinal axis A and a second portion (9b, 10b) inclined with respect to said first portion (9a, 10a).

8. Fan wall module according to claim 7, wherein said first and second portions (9a, 10a; 9b, 10b) are perpendicular.

9. Fan wall module according to any of claims 3 to 8, comprising locking means configured to selectively lock said wall (7) in one between said first and second configurations.

10. Fan wall module according to any of claims 3 to 9, comprising actuator means configured to automatically move said wall (7) between said first and second configurations in function of a control signal.

11. Fan wall module according to any of the preceding claims, comprising conduits (20) for allowing the circulation of a conditioning fluid between said first and second portions (3a, 3b) and a main return and feeding conduits (21, 22) fluidly connected to said conduits (20) and configured to allow the partition and the collection of said conditioning fluid among different fan wall modules (4), said fan wall module (4) comprising a main portion (21a, 22a) of said main feeding and return conduits (21, 22) rigidly carried by said frame (2) and a connection portion (21b, 22b) for connecting together said main portion (21a, 22a) to another main portion (21a, 22a) of another fan wall module (4), said connection portion (21b, 22b) comprising a pair of terminal portions (23', 23") configured to cooperate with said main portions (21a, 22a) and an intermediate portion (24) extending between said terminal portions (23', 23"), said intermediate portion (24) being realized as deformable so that, in a first configuration the terminal portions (23', 23") and said intermediate portion (24) are concentric to a longitudinal axis (B) and in a second configuration wherein they are not concentric to said longitudinal axis (B).

12. Fan wall module according to claim 11, wherein said intermediate portion (24) is realized as a bellow.

13. Fan wall module according to claim 11 or 12, wherein said connection portion (21b, 22b) is cylindrical.

14. Fan wall unit arrangement (1) comprising a plurality of fan wall modules disposed in rows and/or column, said fan wall unit arrangement (1) comprising at least a fan wall module (4) according to any of the preceding claims.

## Patentansprüche

1. Lüfterwandmodul (4) für eine Lüfterwandeinheitsanordnung (1), wobei das Lüfterwandmodul (4) einen Rahmen (2) umfasst, der zur Verbindung mit einem anderen Rahmen (2) von anderen Lüfterwandmodulen (4) geeignet ist, wobei der Rahmen (2) einen Raum (3) begrenzt, der zum Unterbringen einer durch den Rahmen (2) getragenen Wand (7) geeignet ist, wobei das Lüfterwandmodul (4) eine durch die Wand (7) gestützte Lüfterbaugruppe (6) umfasst, wobei die Wand (7) den Raum (3) in einen ersten Abschnitt (3a) und einen zweiten Abschnitt (3b) unterteilt, **dadurch gekennzeichnet, dass** die Wand (7) durch den Rahmen (2) auf eine bewegbare Weise getragen wird, sodass der erste Abschnitt (3a) über den zweiten Abschnitt (3b) erreicht werden kann.

2. Lüfterwandmodul nach Anspruch 1, wobei der erste Abschnitt (3a) ein Überdruckabschnitt ist und der zweite Abschnitt (3b) ein Unterdruckabschnitt gemäß einem Standardbetrieb der Lüfterbaugruppe ist.

3. Lüfterwandmodul nach Anspruch 1 oder 2, wobei die Wand (7) auf eine bewegbare Weise getragen ist, um eine Vielzahl von Positionen zwischen einer ersten geschlossenen Auslegung, bei der der erste Abschnitt (3a) und der Abschnitt (3b) durch die Wand (7), die an dem Rahmen (2) befestigt ist, getrennt sind, und einer zweiten geöffneten Auslegung, bei der der erste Abschnitt (3a) und der Abschnitt (3b) mit einer maximalen Durchgangsfläche zwischen ihnen, einzunehmen.

4. Lüfterwandmodul nach Anspruch 3, wobei die Wand (7) parallel zu einer Längsachse (A) des Lüfterwandmoduls (4) positioniert ist, wenn sie sich in der ersten Auslegung befindet, und wobei die Wand (7) senkrecht zu der Längsachse (A) positioniert ist, wenn sie sich in der zweiten Auslegung befindet.

5. Lüfterwandmodul nach einem der Ansprüche 3 oder 4, umfassend Führungsmittel (8), die ausgelegt sind, um die Wand (7) auf gleitende Weise in Bezug auf den Rahmen (2) zu stützen, um die Auslegungen zu erzielen.

6. Lüfterwandmodul nach Anspruch 5, wobei die Führungsmittel (8) eine obere und eine untere Schiene (9, 10) umfassen, wobei die Wand (7) Gleitmittel (11) umfasst, die ausgelegt sind, um auf gleitende Weise mit der oberen und unteren Schiene (9, 10) zusammenzuwirken.

7. Lüfterwandmodul nach Anspruch 6 in Kombination mit Anspruch 4, wobei die obere und untere Schiene (9, 10) einen ersten Abschnitt (9a, 10a) parallel zu der Längsachse A und einen zweiten Abschnitt (9b, 10b), der in Bezug auf den ersten Abschnitt (9a, 10a) geneigt ist, aufweisen.

8. Lüfterwandmodul nach Anspruch 7, wobei der erste und zweite Abschnitt (9a, 10a; 9b, 10b) senkrecht sind.

9. Lüfterwandmodul nach einem der Ansprüche 3 bis 8, umfassend Verriegelungsmittel, die ausgelegt sind, um die Wand (7) wahlweise in der ersten oder zweiten Auslegung zu verriegeln.

10. Lüfterwandmodul nach einem der Ansprüche 3 bis 9, umfassend Aktormittel, die ausgelegt sind, um die Wand (7) abhängig von einem Steuersignal automatisch zwischen der ersten und zweiten Auslegung zu bewegen.

11. Lüfterwandmodul nach einem der vorhergehenden Ansprüche, umfassend Leitungen (20) zum Ermöglichen der Zirkulation eines Konditionierungsfluids zwischen dem ersten und zweiten Abschnitt (3a, 3b) und eine Hauptrücklaufleitung und eine Hauptzulaufleitung (21, 22), die fluidisch mit den Leitungen (20) verbunden und ausgelegt sind, um die Aufteilung und das Sammeln des Konditionierungsfluids zwischen unterschiedlichen Lüfterwandmodulen (4) zu ermöglichen, wobei das Lüfterwandmodul (4) einen Hauptabschnitt (21a, 22a) der Hauptzulaufleitung und Hauptrücklaufleitung (21, 22), der starr durch den Rahmen (2) getragen wird, und einen Verbindungsabschnitt (21b, 22b) zum Verbinden des Hauptabschnitts (21a, 22a) mit einem anderen Hauptabschnitt (21a, 22a) eines anderen Lüfterwandmoduls (4) umfasst, wobei der Verbindungsabschnitt (21b, 22b) ein Paar von Endabschnitten (23', 23"), die ausgelegt sind, um mit den Hauptabschnitten (21a, 22a) zusammenzuwirken, und einen Zwischenabschnitt (24), der sich zwischen den Endabschnitten (23', 23") erstreckt, umfasst, wobei der Zwischenabschnitt (24) verformbar ausgebildet ist, sodass die Endabschnitte (23', 23") und der Zwischenabschnitt (24) in einer ersten Auslegung zu einer Längsachse (B) konzentrisch sind und in einer zweiten Auslegung nicht konzentrisch zu der Längsachse (B) sind.

12. Lüfterwandmodul nach Anspruch 11, wobei der Zwischenabschnitt (24) als Faltenbalg ausgebildet ist.

13. Lüfterwandmodul nach Anspruch 11 oder 12, wobei der Verbindungsabschnitt (21b, 22b) zylindrisch ist.

14. Lüfterwandeinheitsanordnung (1), umfassend eine Vielzahl von in Reihen und/oder Spalten angeordneten Lüfterwandmodulen, wobei die Lüfterwandeinheitsanordnung (1) mindestens ein Lüfterwandmodul (4) nach einem der vorhergehenden Ansprüche umfasst.

## Revendications

1. Module (4) de paroi de ventilateur destiné à un agencement d'unité (1) de paroi de ventilateur, ledit module (4) de paroi de ventilateur comprenant un châssis (2) adapté pour être relié à d'autres châssis (2) d'autres modules (4) de paroi de ventilateur, ledit châssis (2) délimitant un espace (3) adapté pour loger une paroi (7) portée par le châssis (2), ledit module (4) de paroi de ventilateur comprenant un ensemble ventilateur (6) supporté par ladite paroi (7), ladite paroi (7) divisant ledit espace (3) en une première partie (3a) et une seconde partie (3b), **caractérisé en ce que** ladite paroi (7) est portée par ledit châssis (2) de manière mobile, de sorte que ladite première partie (3a) puisse être accessible par l'intermédiaire de ladite seconde partie (3b).

2. Module de paroi de ventilateur selon la revendication 1, ladite première partie (3a) étant une partie de pression positive et ladite seconde partie (3b) étant une partie de pression négative selon un fonctionnement standard dudit ensemble ventilateur.

3. Module de paroi de ventilateur selon la revendication 1 ou 2, ladite paroi (7) étant portée de manière mobile afin d'adopter une pluralité de positions entre une première configuration, fermée, dans laquelle ladite première partie (3a) et ladite partie (3b) sont séparées par ladite paroi (7) qui est fixée audit châssis (2), et une seconde configuration, ouverte, dans laquelle ladite première partie (3a) et ladite partie (3b) présentent entre elles un passage de zone maximale.

4. Module de paroi de ventilateur selon la revendication 3, ladite paroi (7) étant positionnée parallèlement à un axe longitudinal (A) dudit module (4) de paroi de ventilateur lorsqu'elle se trouve dans ladite première configuration et ladite paroi (7) étant positionnée perpendiculairement audit axe longitudinal (A) lorsqu'elle se trouve dans ladite seconde configuration.

5. Module de paroi de ventilateur selon l'une quelconque des revendications 3 ou 4, comprenant des moyens de guidage (8) configurés pour supporter la paroi (7) de manière coulissante par rapport audit châssis (2) afin d'obtenir lesdites configurations.

6. Module de paroi de ventilateur selon la revendication 5, lesdits moyens de guidage (8) comprenant des rails supérieur et inférieur (9, 10), ladite paroi (7) comprenant des moyens de coulissement (11) configurés pour coopérer avec lesdits rails supérieur et inférieur (9, 10) de manière coulissante.

7. Module de paroi de ventilateur selon la revendication 6, en combinaison avec la revendication 4, lesdits rails supérieur et inférieur (9, 10) comprenant une première partie (9a, 10a) parallèle audit axe longitudinal A et une seconde partie (9b, 10b) inclinée par rapport à ladite première partie (9a, 10a).

8. Module de paroi de ventilateur selon la revendication 7, lesdites première et seconde parties (9a, 10a ; 9b, 10b) étant perpendiculaires.

9. Module de paroi de ventilateur selon l'une quelconque des revendications 3 à 8, comprenant des moyens de verrouillage configurés pour verrouiller sélectivement ladite paroi (7) dans l'une desdites première et seconde configurations.

10. Module de paroi de ventilateur selon l'une quelconque des revendications 3 à 9, comprenant des moyens d'actionnement configurés pour déplacer automatiquement ladite paroi (7) entre lesdites première et seconde configurations en fonction d'un signal de commande.

11. Module de paroi de ventilateur selon l'une quelconque des revendications précédentes, comprenant des conduits (20) destinés à permettre la circulation d'un fluide de conditionnement entre lesdites première et seconde parties (3a, 3b) et des conduits principaux de retour et d'alimentation (21, 22) reliés de manière fluidique auxdits conduits (20) et configurés pour permettre la séparation et la collecte dudit fluide de climatisation parmi différents modules (4) de paroi de ventilateur, ledit module (4) de paroi de ventilateur comprenant une partie principale (21a, 22a) desdits conduits principaux d'alimentation et de retour (21, 22) portés de manière rigide par ledit châssis (2) et une partie de raccordement (21b, 22b) destinée à raccorder entre elles ladite partie principale (21a, 22a) à une autre partie principale (21a, 22a) d'un autre module (4) de paroi de ventilateur, ladite partie de raccordement (21b, 22b) comprenant une paire de parties d'extrémité (23', 23") configurées pour coopérer avec lesdites parties principales (21a, 22a) et une partie intermédiaire (24) s'étendant entre lesdites parties d'extrémité (23', 23"), ladite partie intermédiaire (24) étant réalisée de manière déformable de sorte que, dans une première configuration, les parties d'extrémité (23', 23") et ladite partie intermédiaire (24) soient concentriques à un axe longitudinal (B) et, dans une seconde configuration, qu'elles ne soient pas concentriques audit axe longitudinal (B).

12. Module de paroi de ventilateur selon la revendication 11, ladite partie intermédiaire (24) étant réalisée comme un soufflet.

13. Module de paroi de ventilateur selon la revendication 11 ou 12, ladite partie de raccordement (21b, 22b) étant cylindrique.

14. Agencement d'unité (1) de paroi de ventilateur comprenant une pluralité de modules de paroi de ventilateur disposés en rangées et/ou en colonnes, ledit agencement d'unité (1) de paroi de ventilateur comprenant au moins un module (4) de paroi de ventilateur selon l'une quelconque des revendications précédentes.
